# EUROPEAN PATENT APPLICATION

(11) **EP 2 863 548 A1**
(43) Date of publication of application: **22.04.2015**
(21) Application number: 14275122.1
(22) Date of filing: 16.05.2014
(51) Int. Cl.: H03M 13/35, H03M 13/37

(54) **Data transmission method performing Luby transform (LT) coding in a broadcasting scheme**

(30) Priority: 15.10.2013 KR 20130122776
(71) Applicant: Samsung Electro-Mechanics Co., Ltd., Suwon-Si, Gyeonggi-Do (KR)
(72) Inventor: Choi, Byong Hyok, Gyeonggi-Do (KR)
(74) Representative: Potter Clarkson LLP

(57) **Abstract**

A data transmission method may include: dividing original data to be transmitted from a transmitting node to a plurality of receiving nodes into a plurality of sub groups having K (K being a natural number equal to or larger than 1) packets, performing Luby transform (LT) coding on the respective K packets in all of the plurality of sub groups to generate a plurality of transmission packets, and transmitting the plurality of transmission packets to the plurality of receiving nodes in a broadcast scheme.

## Description

### CROSS-REFERENCE TO RELATED APPLICATION

This application claims the benefit of Korean Patent Application No. 10-2013-0122776 filed on October 15, 2013, with the Korean Intellectual Property Office, the disclosure of which is incorporated herein by reference.

### BACKGROUND

The present disclosure relates to a data transmission method.

When a single transmitting node divides a large amount of large-capacity data into N number of packets and broadcasts the N number of packets to a plurality of receiving nodes, in a case in which all of the plurality of receiving nodes successfully receive a first packet, the transmitting node transmits a second packet to all of the plurality of receiving nodes in the same manner as the transmission of the first packet. Subsequently, the above-described process is repeated continuously until the successful transmission of an N-th packet, the final packet, to all the receiving nodes has been completed.

As described above, when the single transmitting node transmits the large-capacity data to the plurality of receiving nodes, a required total number of transmissions may be a number equal to tens of times greater than N, the number of original data packets. Therefore, such a broadcast scheme may have a problem in that the efficiency of a wireless channel and a battery may be reduced.

The following Related Art Document relates to a multi source multicast transmission scheme, in which packets are mixed and transmitted based on a multicast group at the time of applying network coding to a network based on the multi source multicast transmission to be able to improve network effective throughput. However, the following Related Art Document requires an inverse matrix operation to decode the original data packets because of using the network coding and therefore requires high quality hardware.

### [Related Art Document]

Korean Patent Laid-Open Publication No. 10-2012-0085508

### SUMMARY

Some embodiments of the present disclosure may provide a data transmission method capable of reducing decoding complexity by using Luby transform (LT) codes instead of using network coding and significantly reducing the number of transmissions by dividing original data packets into sub groups including a predetermined number of packets to transmit data.

According to some embodiments of the present disclosure, a data transmission method includes: dividing original data to be transmitted from a transmitting node to a plurality of receiving nodes into a plurality of sub groups having K (K being a natural number equal to or larger than 1) packets; performing Luby transform (LT) coding on the respective K packets in all of the plurality of sub groups to generate a plurality of transmission packets; and transmitting the plurality of transmission packets to the plurality of receiving nodes in a broadcast scheme.

The original data may be configured of N (N being a natural number equal to or larger than K) packets.

The generating of the plurality of transmission packets may include: selecting a d value (natural number) equal to or larger than 1 and equal to or smaller than K; selecting the d packets among the K packets; and performing the LT coding on the selected d packets based on an exclusive OR operation.

The data transmission method may further include: setting the value of K according to information regarding states of the plurality of receiving nodes.

The transmitting may include: selecting one of the plurality of sub groups in a preset scheme; transmitting the plurality of transmission packets included in the selected one sub group to the plurality of receiving nodes; receiving, by the transmitting node, transmission acknowledgement signals for the plurality of transmission packets from all of the plurality of receiving nodes receiving the plurality of transmission packets; and confirming whether the transmitting node receives the transmission acknowledgement signals from all of the plurality of receiving nodes receiving the plurality of transmission packets.

The data transmission method may further include: when the transmitting node receives the transmission acknowledgement signals from all of the plurality of receiving nodes, repeating the selecting, the transmitting, the receiving, and the confirming for remaining sub groups other than the selected one of the plurality of sub groups.

The transmitting may include: selecting one of the plurality of sub groups in a preset scheme; transmitting the plurality of transmission packets included in the selected one sub group to the plurality of receiving nodes in a preset number of transmissions; and repeating the selecting and the transmitting for the respective remaining sub groups other than the selected group among the plurality of sub groups.

According to some embodiments of the present disclosure, a data transmission method includes: dividing original data to be transmitted from a transmitting node to a plurality of receiving nodes into a plurality of sub groups having K (K being a natural number equal to or larger than 1) packets; selecting one of the plurality of sub groups in a preset scheme; performing Luby transform (LT) coding on the respective K packets included in the selected one sub group to generate a plurality of transmission packets; transmitting the plurality of transmission packets to the plurality of receiving nodes in a broadcast scheme; and when there are non-selected sub groups among the plurality of sub groups, repeating the selecting, the performing of the LT coding, and the transmitting for the non-selected sub groups.

The original data may be configured of N (N being a natural number larger than 1) packets.

The performing of the LT coding may include: selecting a d value (natural number) equal to or larger than 1 and equal to or smaller than K; selecting the d packets among the K packets; and performing the LT coding on the selected d packets based on an exclusive OR operation.

The transmitting may include: receiving, by the transmitting node, transmission acknowledgement signals for the plurality of transmission packets from the plurality of receiving nodes receiving the plurality of transmission packets; and confirming whether the transmitting node receives the transmission acknowledgement signals from all of the plurality of receiving nodes receiving the plurality of transmission packets.

The transmitting may include: transmitting the plurality of transmission packets included in the selected one sub group to the plurality of receiving nodes in a preset number of transmissions.

The dividing may include: setting the value of K according to information regarding states of the plurality of receiving nodes.

According to some embodiments of the present disclosure a data transmission method may include: dividing original data to be transmitted from a transmitting node to a plurality of receiving nodes into a plurality of sub groups having K (K being a natural number equal to or larger than 1) packets; performing Luby transform (LT) coding on the plurality of respective sub groups to generate the plurality of transmission packets; selecting one of the plurality of sub groups in a preset scheme; transmitting the plurality of transmission packets included in the selected one sub group to the plurality of receiving nodes in a broadcast scheme; receiving, by the selected one sub group, transmission acknowledgement signals for the plurality of transmission packets from the plurality of receiving node receiving the plurality of transmission packets; confirming whether the selected one sub group receives transmission acknowledgement signals from all of the plurality of receiving nodes receiving the plurality of transmission packets; and when the selected one sub group receives the transmission acknowledgement signals from all of the plurality of receiving nodes, repeating the selecting, the transmitting, the receiving, and the confirming for remaining groups other than the selected one of the plurality of sub groups.

The original data may be configured of N (N being a natural number larger than 1) packets.

The performing of the LT coding may include: selecting a d value (natural number) equal to or larger than 1 and equal to or smaller than K; selecting the d packets among the K packets; and performing the LT coding on the selected d packets based on an exclusive OR operation.

The dividing may include: setting the number of K values according to information regarding states of the plurality of receiving nodes.

### BRIEF DESCRIPTION OF DRAWINGS

The above and other aspects, features and other advantages of the present disclosure will be more clearly understood from the following detailed description taken in conjunction with the accompanying drawings, in which:
FIG. 1 is a flow chart illustrating a data transmission method according to an exemplary embodiment of the present disclosure;
FIG. 2 is a flow chart illustrating in detail a method of generating a plurality of transmission packets in the data transmission method of FIG. 1;
FIG. 3 is an exemplified diagram illustrating the method of generating a plurality of transmission packets illustrated in FIG. 2;
FIG. 4 is a graph illustrating the method of generating a plurality of transmission packets illustrated in FIG. 2;
FIG. 5 is a flow chart illustrating in more detail an example of the data transmission method of FIG. 1;
FIG. 6 is a flow chart illustrating in more detail another example of the data transmission method of FIG. 1;
FIG. 7 is a flow chart illustrating a data transmission method according to another exemplary embodiment of the present disclosure;
FIGS. 8 and 9 are flow charts illustrating in more detail the data transmission method of FIG. 7; and
FIG. 10 is a flow chart illustrating a data transmission method according to another exemplary embodiment of the present disclosure.

### DETAILED DESCRIPTION

Hereinafter, embodiments of the present disclosure will be described in detail with reference to the accompanying drawings. The disclosure may, however, be embodied in many different forms and should not be construed as being limited to the embodiments set forth herein. Rather, these embodiments are provided so that this disclosure will be thorough and complete, and will fully convey the scope of the disclosure to those skilled in the art. Throughout the drawings, the same or like reference numerals will be used to designate the same or like elements.

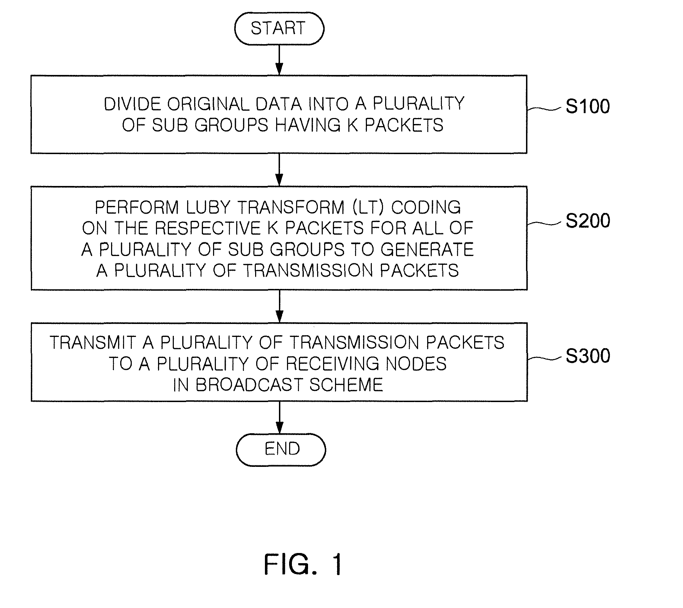

FIG. 1 is a flow chart illustrating a data transmission method according to an exemplary embodiment of the present disclosure.

Referring to FIG. 1, the data transmission method according to the exemplary embodiment of the present disclosure may include: dividing original data to be transmitted from a transmitting node to a plurality of receiving nodes into a plurality of sub groups having K packets (S100); performing Luby transform coding on the respective K packets in all of the plurality of sub groups to generate a plurality of transmission packets (S200); and transmitting the plurality of transmission packets to the plurality of receiving nodes for a respective sub group in a broadcast scheme (S300).

The K may be a natural number equal to or larger than 1, and in more detail, may be determined in consideration of a hardware option of the plurality of receiving nodes.

According to one exemplary embodiment of the present disclosure, when the original data are configured of N (N is a natural number equal to or larger than K) packets, K may be a value (natural number) at least 40% (2/5) or more than N and the transmitting node may divide the original data to be transmitted to the plurality of receiving nodes into the plurality of sub groups having the K packets and may perform the LT coding on all of the sub groups to generate the plurality of transmission packets.

In other words, the transmitting node may divide the original data configured of N packets into the plurality of sub groups having the K packets and may generate the plurality of LT coded transmission packets for the plurality of sub groups. In this case, the LT coding is a kind of Rateless coding and may generate and transmit the N packets of the original data based on an exclusive OR operation, a kind of binary linear combination, such that the LT coding does not require an inverse matrix operation at all, unlike the network coding requiring the inverse matrix operation to decode the N original data packets, to thereby further reduce decoding complexity.

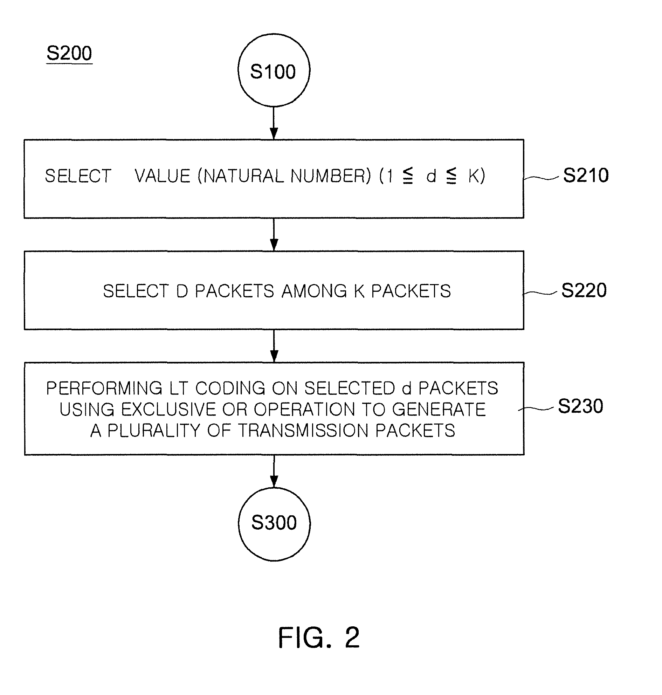

The data transmission method according to the exemplary embodiment of the present disclosure will be described in more detail with reference to FIGS. 2 through 4.

FIG. 2 is a flow chart illustrating in more detail a method of generating the plurality of transmission packets (S200) in the data transmission method of FIG. 1.

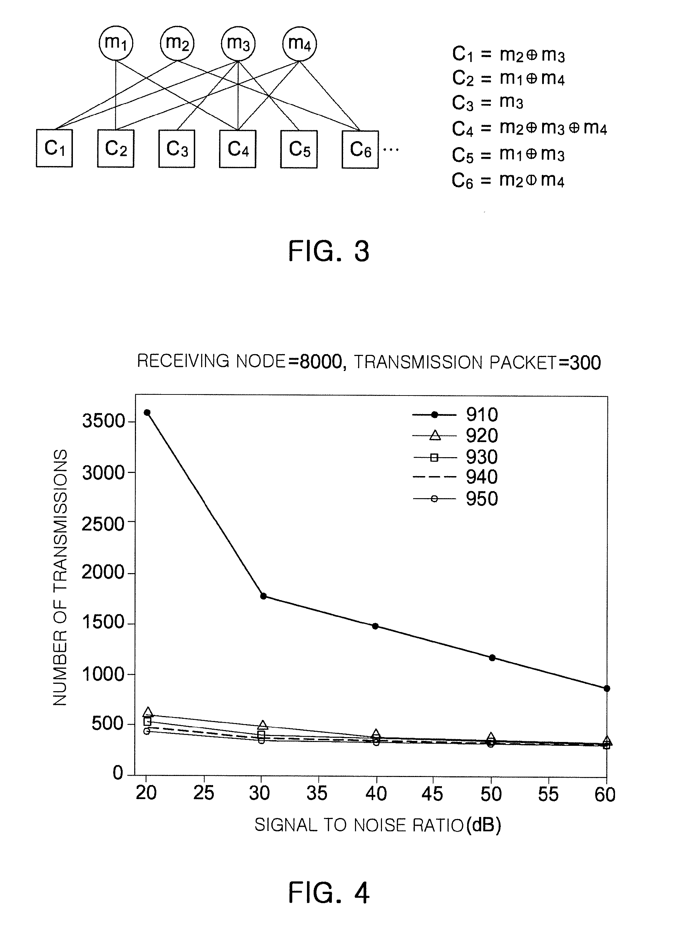

FIG. 3 is an exemplified diagram illustrating the method of generating a plurality of transmission packets illustrated in FIG. 2.

FIG. 4 is a graph illustrating the method of generating a plurality of transmission packets illustrated in FIG. 2.

Referring to FIG. 2, the generating of the plurality of transmission packets may include selecting a degree (d) value (S210), selecting d packets among the K packets (S220), and performing the LT coding on the selected d packets using the exclusive OR operation to generate the plurality of transmission packets (S230). In this case, the foregoing d value may be a natural number equal to or larger than 1 and equal to or smaller than K.

The method of generating a plurality of transmission packets will be described in detail with reference to FIG. 3, by way of example.

Referring to FIG. 3, the original data are configured of four packets m1, m2, m3, and m4. Meanwhile, the LT coded transmission packet may be plural (c1, c2, c3, c5, c6 as illustrated in FIG. 3). For example, the first LT coded transmission packet c1 may be generated by performing the exclusive OR operation on the second original data packet m2 and the third original data packet m3. Similarly, the transmitting node may continuously generate the remaining LT coded transmission packets depending on the given d value.

Therefore, the plurality of respective receiving nodes which receive as many of the LT coded transmission packets as N original data packets which may be decoded do not require an inverse matrix of a generation matrix, and therefore may perform the decoding with relatively, significantly lower decoding complexity.

For example, when one of the plurality of receiving nodes receives a third transmission packet c3, the second original data packet m2 may be decoded by re-performing the exclusive OR operation with the first transmission packet c1 and the fourth original data packet m4 may be decoded by re-performing the exclusive OR operation on the second original data packet m2 with the sixth transmission packet c6.

However, even when the LT coding is used instead of using the network coding, in the case of receiving nodes in relatively low quality hardware, decoding the N original data packets all at once may increase decoding complexity. Therefore, the N original data packets are divided into the plurality of sub groups having the K packets and the plurality of transmission packets generated by performing the LT coding on all of the plurality of sub groups are transmitted to the plurality of receiving nodes, such that the decoding complexity may be reduced.

Next, the data transmission method capable of reducing the decoding complexity by dividing the N original data packets into the plurality of sub groups having the K packets will be described in detail.

**[Table 1]**

| Number (K) of packets within sub groups | K=10 | K=25 | K=50 | K=100 | K=300 |
|---|---|---|---|---|---|
| Absolute decoding complexity K*logₑ (K) | 23 | 81 | 196 | 461 | 1711 |
| Relative decoding complexity (based on K = 25) | 0.29 | 1 | 2.43 | 5.72 | 21.26 |

The case that the number of original data packets is N and the original data are divided into the plurality of sub groups having the K packets to be transmitted is provided.

For example, referring to Table 1, the absolute decoding complexity of the LT coding may be K*logₑ(K) and represents the relative decoding complexity depending on the number (K) of packets within the plurality of sub groups based on the absolute decoding complexity K*logₑ(K). For example, in a case in which when K = 25, the relative decoding complexity is 1, it may be appreciated that when K = 50, the decoding complexity is increased about 2.43 times, and when K = 300, the decoding complexity is increased about 21 times. Therefore, when the original data packets are divided into the sub groups having the K packets and numbers of transmissions of the LT coded transmission packets are compared, it may be appreciated that the case in which the original data packets are sub grouped and transmitted so that K = 25 may reduce the decoding complexity by about 1/21 without additionally increasing the number of transmissions, as compared to the case of transmitting the original data in a single transmission scheme without sub grouping the original data.

Referring to FIG. 4, when the number K of packets within the plurality of sub groups is increased, the number of transmissions to transmit the original data is reduced, but the decoding complexity is increased as illustrated in Table 1. Therefore, the value of K needs to be selected according to the hardware quality of the receiving node to perform the decoding, and in more detail, setting the value of K according to information regarding states of the plurality of receiving nodes may be added.

For example, in the case of the receiving node having high-performance MCU and memory, a large number of packets may be received and decoded at once and therefore a relatively large K value may be used, and in the case of the receiving node having low-performance MCU and memory, a relatively small K value which may be received and decoded by the memory may be used. Therefore, the transmitting node receives the information regarding states of the plurality of receiving nodes in advance and thus the value of K corresponding thereto may be set.

When the number of receiving nodes is 8,000 and the number N of original data packets is 300, the number of times where the transmitting node transmits the transmission packets to a signal to noise ratio (SNR, unit (dB)) is illustrated in the graph illustrated in FIG. 4.

In this case, a case 910 in which the transmission packets are simply transmitted in the broadcast scheme, indicates a scheme of repeatedly transmitting 300 packets until the plurality of receiving nodes receive all the packets based on one cycle in which the transmitting node transmits 300 packets of the original data. Further, each of the cases 920, 930, and 940 in which the original data are divided into the plurality of sub groups having the K packets to generate and transmit the LT coded transmission packets for all of the respective sub groups indicates a scheme of dividing the original data into the plurality of sub groups having the K (920: K is 25, 930: K is 50, and 940: K is 100) packets and repeatedly transmitting 300 transmission packets based on the LT coding.

Meanwhile, a case 950 of performing the LT coding to transmit the transmission packets indicates a scheme of generating and transmitting the LT coded transmission packets based on the 300 transmission packets of the original data without dividing the original data into the plurality of sub groups having the K packets.

Referring to FIG. 4, as compared with the case 910 in which the transmission packets are simply transmitted in the broadcast scheme, it may be appreciated that the case 920 in which K = 25 may reduce the number of transmissions by at least 60%. Further, as compared with the case of performing the LT coding to transmit the transmission packets without dividing the transmission packets into the sub groups, it may be appreciated that the case 920 in which K = 25 may relatively reduce the decoding complexity while showing the similar performance.

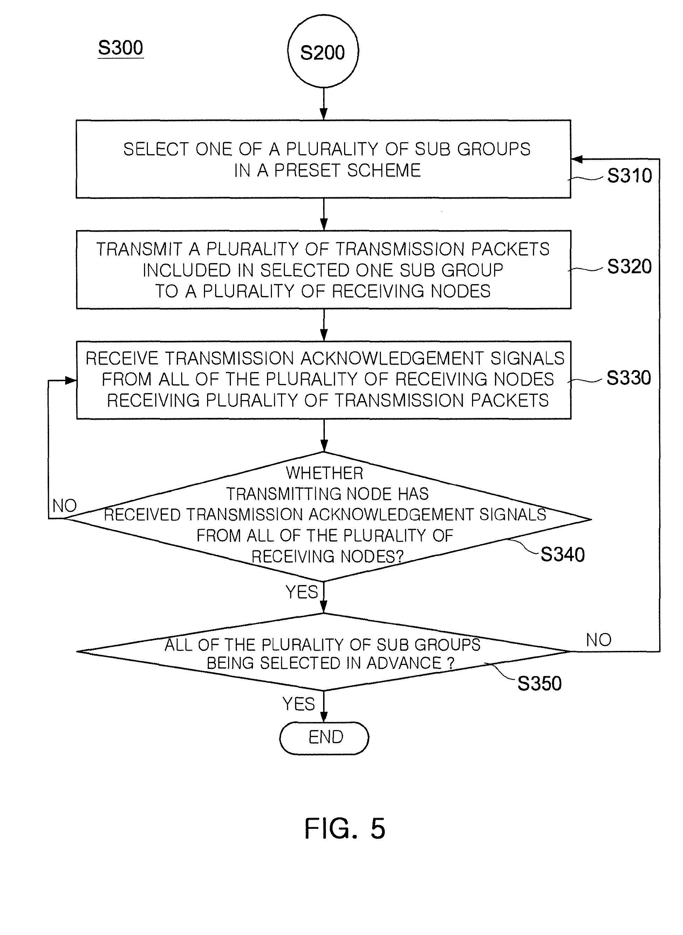

FIG. 5 is a flow chart illustrating in more detail an example of the data transmission method of FIG. 1.

Referring to FIG. 5, the transmitting (S300) according to the exemplary embodiment of the present disclosure may include: selecting one of the plurality of sub groups in a preset scheme (S310); transmitting the plurality of transmission packets included in the selected one sub group to the plurality of receiving nodes (S320); receiving, by the transmitting node, transmission acknowledgement signals for the plurality of transmission packets from all of the plurality of receiving nodes receiving the plurality of transmission packets (S330); and confirming whether the transmitting node has received the transmission acknowledgement signals from all of the plurality of receiving nodes (S340).

Further, the transmitting (S300) may further include confirming whether the transmitting, the receiving, and the confirming are performed on all of the plurality of sub groups. For example, the transmitting (S300) may further include repeating the selecting, the transmitting, the receiving, and the confirming for the remaining groups other than the selected one of the K sub groups, when the transmission acknowledgement signals from all of the plurality of receiving nodes are received (S350).

Described in more detail, when one transmitting node simultaneously broadcasts the transmission packets to the plurality of receiving nodes, in a case in which relatively many receiving nodes transmit the transmission acknowledgement signals for whether respective packets are received to the transmitting node, the probability of collision occurrence may be increased.

Therefore, only the receiving node sufficiently receiving the plurality of transmission packets required to decode the original data packets transmits the transmission acknowledgement signal, and thus the transmitting node may know whether respective receiving nodes have received the required transmission packets.

For example, one of the plurality of sub groups including the K packets may be selected by the preset scheme (S310) and the plurality of transmission packets included in the selected one sub group may be transmitted to the plurality of receiving nodes (S320). Next, only the receiving node sufficiently receiving the plurality of transmission packets required to decode the original data packets may transmit the transmission acknowledgement signal and may continuously repeatedly transmit the transmission acknowledgement signal to allow the transmitting node to receive the transmission acknowledgement signals from all of the plurality of receiving nodes (S330).

Next, it may be confirmed whether the transmitting node has received the transmission acknowledgement signals from all of the plurality of receiving nodes (S340) and when it is confirmed that the transmitting node has received the transmission acknowledgement signals from all of the plurality of receiving nodes, the above processes may be repeated for the remaining sub groups (S350). For example, when one sub group is selected from the plurality of sub groups having the K packets and thus the transmission acknowledgement signals from all of the plurality of receiving nodes are received, the above processes may be repeated for the remaining sub groups other than the one sub group.

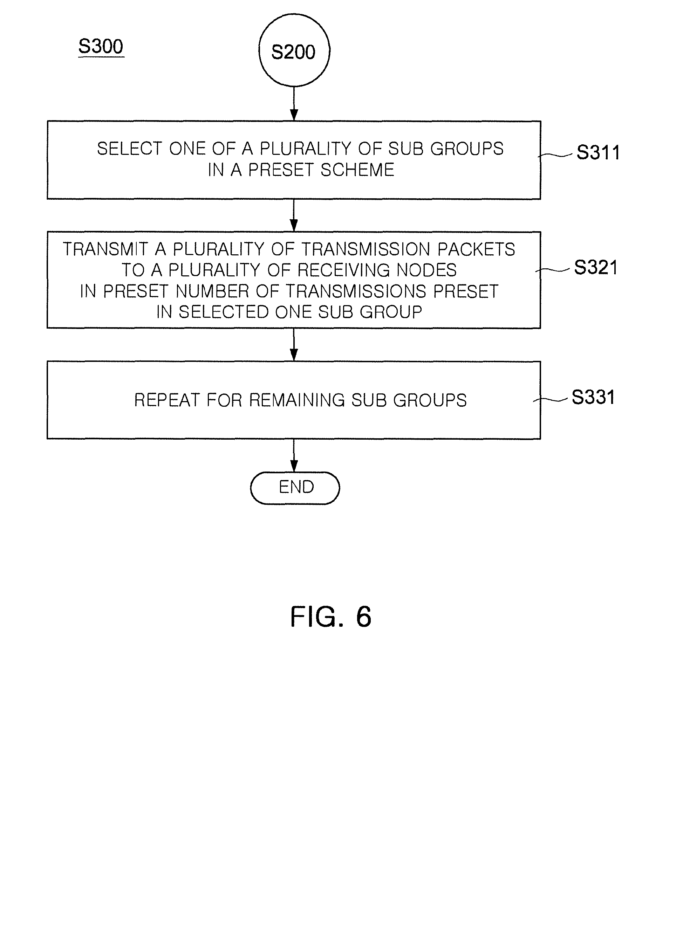

Meanwhile, unlike the method illustrated in FIG. 5, the data transmission method according to the exemplary embodiment of the present disclosure may transmit the plurality of transmission packets to the plurality of receiving nodes without the transmission acknowledgement signals. This will be described with reference to FIG. 6.

FIG. 6 is a flow chart illustrating in more detail another example of the data transmission method of FIG. 1.

Referring to FIG. 6, the data transmission method may include: selecting the one sub group from the plurality of sub groups having the K packets in the preset scheme (S311); transmitting the plurality of transmission packets to the plurality of receiving nodes by the preset number of transmissions preset in the selected one sub group (S321); and repeating the selecting and the transmitting for the remaining sub groups other than the groups selected from the plurality of sub groups (S331).

In this case, the preset number of transmissions may be preset in consideration of the value of K, the number of the plurality of receiving nodes, communication environment, and the like. For example, the transmitting node need not receive the transmission acknowledgement signals from the plurality of receiving nodes, and may therefore broadcast the original data packets to the plurality of receiving nodes in a relatively short time.

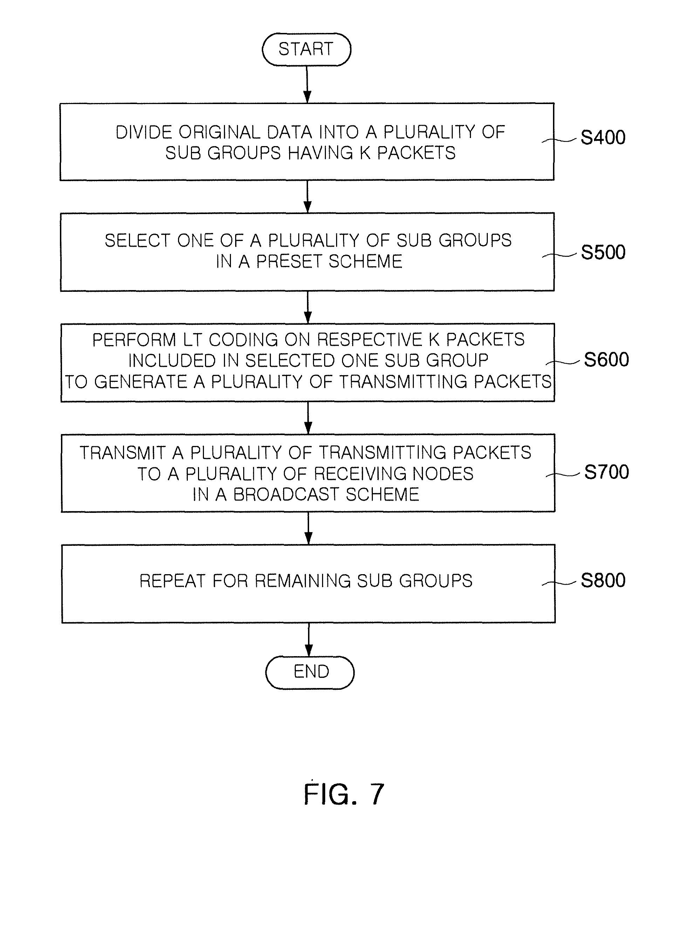

FIG. 7 is a flow chart illustrating a data transmission method according to another exemplary embodiment of the present disclosure.

Referring to FIG. 7, a data transmission method according to another exemplary embodiment of the present disclosure may include: dividing original data to be transmitted from a transmitting node to a plurality of receiving nodes into a plurality of sub groups having K packets (S400); selecting at least one of the plurality of sub groups in a preset scheme (S500); performing LT coding on the respective K packets included in the selected one sub group to generate a plurality of transmission packets (S600); transmitting the plurality of transmission packets to the plurality of receiving nodes in a broadcast scheme (S700); and when there are non-selected sub groups among the plurality of sub groups, repeating the selecting, the LT coding, and the transmitting (S800).

In this case, the original data may be configured of N (a natural number larger than 1) packets and the generating of the plurality of transmission packets is already described and therefore the description thereof will be omitted.

For example, unlike the method of first performing the LT coding on the plurality of respective sub groups and then generating and transmitting the plurality of transmission packets, a data transmission method according to another exemplary embodiment of the present disclosure may include performing LT coding on only one group selected after selecting one of the plurality of sub groups in the preset scheme (S500) to then generate the plurality of transmission packets (S600). Next, the data transmission method may include transmitting the plurality of transmission packets to the plurality of receiving nodes in the broadcast scheme (S700) and identically repeating the above processes on the remaining sub groups other than the selected one sub group (S800).

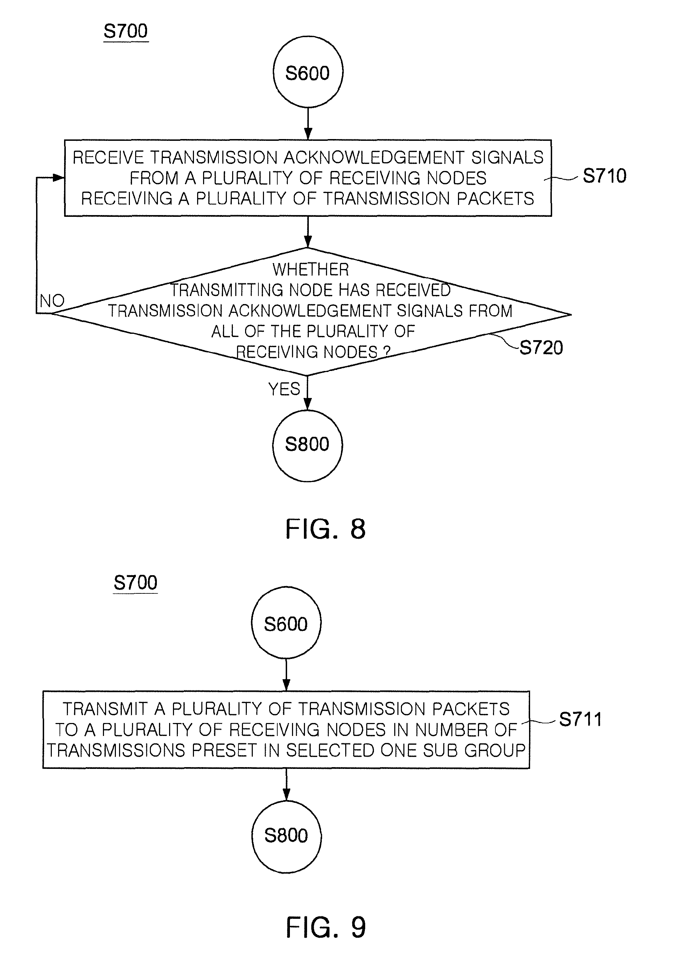

FIGS. 8 and 9 are flow charts illustrating in more detail the data transmission method of FIG. 7.

Referring to FIG. 8, the transmitting of the plurality of transmission packets to the plurality of receiving nodes (S700) may include receiving the transmission acknowledgement signals from the plurality of receiving nodes receiving the plurality of transmission packets (S710) and confirming whether the transmitting node has received the transmission acknowledgement signals from all of the plurality of receiving nodes (S720).

Further, referring to FIG. 9, the transmitting of the plurality of transmission packets to the plurality of receiving nodes (S700) may include the plurality of transmission packets to the plurality of receiving nodes by the preset number of transmissions in the selected one sub group (S711).

The transmitting of the plurality of transmission packets (S710, S720, and S711) has been already described and therefore the description thereof will be omitted.

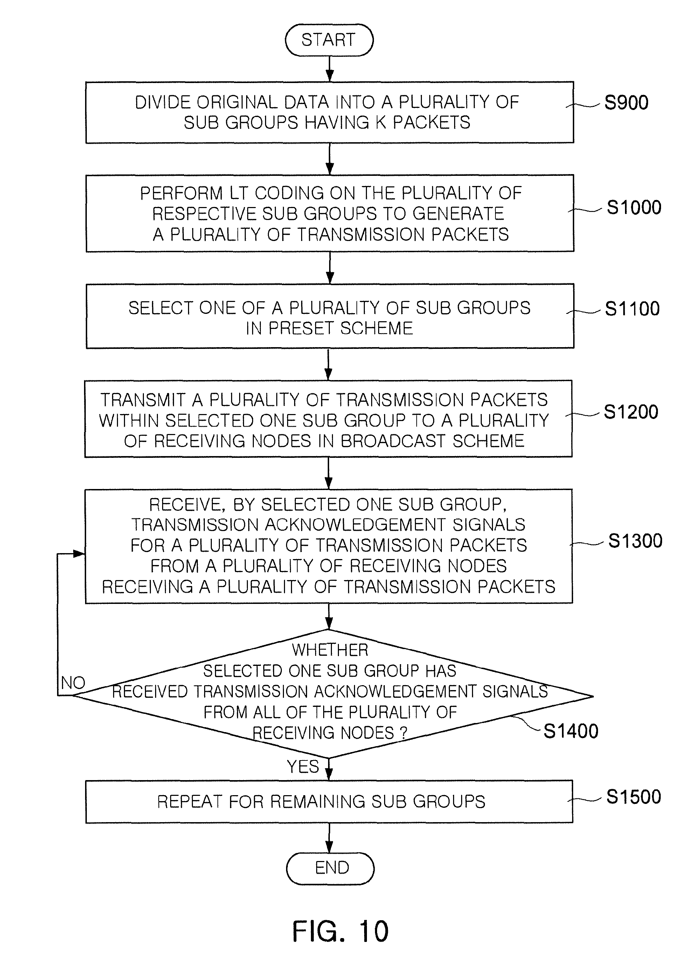

FIG. 10 is a flow chart illustrating a data transmission method according to another exemplary embodiment of the present disclosure.

Referring to FIG. 10, a data transmission method according to another exemplary embodiment of the present disclosure may include: dividing original data to be transmitted from the transmitting node to a plurality of receiving nodes into a plurality of sub groups having K packets (S900); performing Luby transform (LT) coding on the plurality of respective sub groups to generate the plurality of transmission packets (S1000); selecting at least one of the plurality of sub groups in a preset scheme (S1100); transmitting the plurality of transmission packets within the selected one sub group to the plurality of receiving nodes in a broadcast scheme (S1200); receiving, by the selected one sub group, transmission acknowledgement signals for the plurality of transmission packets from the plurality of receiving nodes receiving the plurality of transmission packets (S1300); confirming whether the selected one sub group has received the transmission acknowledgement signals from all of the plurality of receiving nodes (S1400); and repeating the selecting, the transmitting, the receiving, and the confirming when the selected one sub group has received the transmission acknowledgement signals from all of the plurality of receiving nodes (S1500).

The data transmission method forms the original data packets into the sub groups including the predetermined number of packets, performs the LT coding on the sub group, and broadcasts the LT coded sub group, to thereby significantly reduce the number of transmissions. In this way, the decoding complexity may be reduced and even in the case of using the low quality hardware, the data may be efficiently transmitted.

While exemplary embodiments have been shown and described above, it will be apparent to those skilled in the art that modifications and variations could be made without departing from the spirit and scope of the present disclosure as defined by the appended claims.

## Claims

1. A data transmission method, comprising:
dividing original data to be transmitted from a transmitting node to a plurality of receiving nodes into a plurality of sub groups having K (K being a natural number equal to or larger than 1) packets;
performing Luby transform (LT) coding on the respective K packets in all of the plurality of sub groups to generate a plurality of transmission packets; and
transmitting the plurality of transmission packets to the plurality of receiving nodes in a broadcast scheme.

2. The data transmission method of claim 1, wherein the original data are configured of N (N being a natural number equal to or larger than K) packets.

3. The data transmission method of claim 2, wherein the generating of the plurality of transmission packets includes:
selecting a d value (a natural number) equal to or larger than 1 and equal to or smaller than K;
selecting the d packets among the K packets; and
performing the LT coding on the selected d packets based on an exclusive OR operation.

4. The data transmission method of claim 1, further comprising:
setting the value of K according to information regarding states of the plurality of receiving nodes.

5. The data transmission method of claim 1, wherein the transmitting includes:
selecting one of the plurality of sub groups in a preset scheme;
transmitting the plurality of transmission packets included in the selected one sub group to the plurality of receiving nodes;
receiving, by the transmitting node, transmission acknowledgement signals for the plurality of transmission packets from all of the plurality of receiving nodes receiving the plurality of transmission packets; and
confirming whether the transmitting node receives the transmission acknowledgement signals from all of the plurality of receiving nodes receiving the plurality of transmission packets.

6. The data transmission method of claim 5, further comprising:
when the transmitting node receives the transmission acknowledgement signals from all of the plurality of receiving nodes, repeating the selecting, the transmitting, the receiving, and the confirming for remaining sub groups other than the selected one of the plurality of sub groups.

7. The data transmission method of claim 1, wherein the transmitting includes:
selecting one of the plurality of sub groups in a preset scheme;
transmitting the plurality of transmission packets included in the selected one sub group to the plurality of receiving nodes in a preset number of transmissions; and
repeating the selecting and the transmitting for the respective remaining sub groups other than the selected group among the plurality of sub groups.

8. A data transmission method, comprising:
dividing original data to be transmitted from a transmitting node to a plurality of receiving nodes into a plurality of sub groups having K (K being a natural number equal to or larger than 1) packets;
selecting one of the plurality of sub groups in a preset scheme;
performing Luby transform (LT) coding on the respective K packets included in the selected one sub group to generate a plurality of transmission packets;
transmitting the plurality of transmission packets to the plurality of receiving nodes in a broadcast scheme; and
when there are non-selected sub groups among the plurality of sub groups, repeating the selecting, the performing of the LT coding, and the transmitting for the non-selected sub groups.

9. The data transmission method of claim 8, wherein the original data are configured of N (N being a natural number larger than 1) packets.

10. The data transmission method of claim 9, wherein the performing of the LT coding comprises:
selecting a d value (natural number) equal to or larger than 1 and equal to or smaller than K;
selecting the d packets among the K packets; and
performing the LT coding on the selected d packets based on an exclusive OR operation.

11. The data transmission method of claim 8, wherein the transmitting comprises:
receiving, by the transmitting node, transmission acknowledgement signals for the plurality of transmission packets from the plurality of receiving nodes receiving the plurality of transmission packets; and
confirming whether the transmitting node receives the transmission acknowledgement signals from all of the plurality of receiving nodes receiving the plurality of transmission packets.

12. The data transmission method of claim 8, wherein the transmitting includes:
transmitting the plurality of transmission packets included in the selected one sub group to the plurality of receiving nodes in a preset number of transmissions.

13. The data transmission method of claim 8, wherein the dividing includes:
setting the value of K according to information regarding states of the plurality of receiving nodes.

14. A data transmission method, comprising:
dividing original data to be transmitted from a transmitting node to a plurality of receiving nodes into a plurality of sub groups having K (K being a natural number equal to or larger than 1) packets;
performing Luby transform (LT) coding on the plurality of respective sub groups to generate the plurality of transmission packets;
selecting one of the plurality of sub groups in a preset scheme;
transmitting the plurality of transmission packets included in the selected one sub group to the plurality of receiving nodes in a broadcast scheme;
receiving, by the selected one sub group, transmission acknowledgement signals for the plurality of transmission packets from the plurality of receiving nodes receiving the plurality of transmission packets;
confirming whether the selected one sub group receives transmission acknowledgement signals from all of the plurality of receiving nodes receiving the plurality of transmission packets; and
when the selected one sub group receives the transmission acknowledgement signals from all of the plurality of receiving nodes, repeating the selecting, the transmitting, the receiving, and the confirming for remaining groups other than the selected one of the plurality of sub groups.

15. The data transmission method of claim 14, wherein the original data are configured of N (N being a natural number larger than 1) packets.

16. The data transmission method of claim 15, wherein the performing of the LT coding comprises:
selecting a d value (natural number) equal to or larger than 1 and equal to or smaller than K; selecting the d packets among the K packets; and
performing the LT coding on the selected d packets based on an exclusive OR operation.

17. The data transmission method of claim 14, wherein the dividing comprises:
setting the number of K values according to information regarding states of the plurality of receiving nodes.
